# EUROPEAN PATENT SPECIFICATION

(11) **EP 3 324 447 B1**
(45) Date of publication and mention of the grant of the patent: **06.03.2019**
(21) Application number: 17210606.4
(22) Date of filing: 13.01.2017
(51) Int. Cl.: H01L 31/0224, H01L 31/0216, H01L 31/0236, H01L 31/0747, H01L 31/18

(54) **SOLAR CELL**
SOLARZELLE
CELLULE SOLAIRE

(30) Priority: 14.01.2016 KR 20160004964
(43) Date of publication of application: 23.05.2018
(62) Divisional of application: 17151397.1
(73) Proprietor: LG Electronics Inc., Yeongdeungpo-gu Seoul, 07336 (KR)
(72) Inventor: LEE, Hongcheol, 08592 Seoul (KR); LEE, Seungyoon, 08592 Seoul (KR); JI, Kwangsun, 08592 Seoul (KR); CHOI, Minho, 08592 Seoul (KR)
(74) Representative: Katérle, Axel

(56) References cited:
- EP-A1- 2 672 522
- US-A1- 2009 211 627

## Description

### BACKGROUND OF THE INVENTION

### Field of the Invention

Embodiments of the invention relate to a solar cell, and more particularly to a hetero-junction solar cell.

### Background of the Related Art

Recently, research on hetero-junction solar cells has been progressing in order to improve the efficiency of solar cells. Representative hetero-junction solar cells include solar cells using intrinsic-amorphous silicon (i-a-Si) as a passivation layer, and solar cells using a thin tunnel oxide layer as a passivation layer.

The hetero-junction solar cells are formed on front and back surfaces of a semiconductor substrate for a solar cell and include a transparent conductive oxide (TCO) layer that performs an optical function (for example, a function of an anti-reflection layer and a reflection layer) and an electrical function (for example, a contact function with a metal electrode).

EP 2 672 522 A1 discloses a photoelectric conversion element containing a transparent conductive film, a p-type amorphous silicon film, an i-type amorphous silicon film, an n-type single-crystal silicon substrate, an i-type amorphous silicon film, a p-type amorphous silicon film, a transparent conductive film, and a metallic film, and the film thickness of the front and back transparent conductive films are different from each other.

### SUMMARY OF THE INVENTION

An object of the invention is to provide a high efficiency solar cell.

A solar cell according to the present invention is defined in claim 1. Preferred features are defined in the dependent claims. In one aspect useful for understanding the present invention, there is provided a solar cell including a crystalline semiconductor substrate containing impurities of a first conductivity type; a front doped layer located on a front surface of the semiconductor substrate; a back doped layer located on a back surface of the semiconductor substrate; a front transparent conductive layer located on the front doped layer and having a first thickness; a front collector electrode located on the front transparent conductive layer; a back transparent conductive layer located under the back doped layer and having a second thickness; and a back collector electrode located under the back transparent conductive layer. The first thickness of the front transparent conductive layer and the second thickness of the back transparent conductive layer are different from each other, and a sheet resistance of the front transparent conductive layer is less than a sheet resistance of the back transparent conductive layer, wherein the front transparent conductive layer has a thickness (T1) over its entire area and the back transparent conductive layer has a thickness (T2) over its entire area.

In an embodiment useful for understanding the invention, the front transparent conductive layer and the back transparent conductive layer may be formed of the same material, for example, the front transparent conductive layer and the back transparent conductive layer may be formed of a layer containing indium oxide (In₂O₃) as a main component and containing tin (Sn), zinc (Zn), tungsten (W), cerium (Ce) or hydrogen (H) as impurities, or a layer containing indium oxide as a main component and containing at least one of titanium (Ti) and tantalum (Ta) as impurities, or a layer containing zinc oxide (ZnO) as a main component and containing aluminum (Al), boron (B), or gallium (Ga) as impurities, or a layer containing tin oxide (SnO₂) as a main component and containing fluorine (F) as impurities.

In this instance, "the same material" refers to a material having a main component and an impurity identical to each other, and the material having different types of impurities contained therein do not correspond to the same material.

Alternatively, the front transparent conductive layer and the back transparent conductive layer may be formed of different materials.

In an embodiment useful for understanding the invention, an oxygen content of the back transparent conductive layer may be larger than an oxygen content of the front transparent conductive layer.

According to this configuration, since the front transparent conductive layer having an oxygen content smaller than that of the back transparent conductive layer is formed to have a lower sheet resistance than that of the back transparent conductive layer, although reducing the size (width, etc.) of the front collector electrodes to reduce a shading loss due to the front collector electrodes, the front transparent conductive layer can transfer the charge well.

Since the back transparent conductive layer having an oxygen content relatively larger than that of the front transparent conductive layer is formed to have a lower light absorptance than the front transparent conductive layer, the amount of light absorbed in the back transparent conductive layer can be reduced.

In an embodiment useful for understanding the invention, a solar cell may be a bifacial solar cell or a mono-facial solar cell.

In the instance of a bifacial solar cell, each of the front collector electrode and the back collector electrode may include a plurality of finger electrodes extending in a first direction, and at least one bus bar electrode extending in a second direction orthogonal to the first direction and physically connected to the plurality of finger electrodes.

In this instance, the second thickness of the back transparent conductive layer may be less than the first thickness of the front transparent conductive layer.

According to an experiment useful for understanding the invention, in the laminated structure of the silicon / transparent conductive layer, it can be seen that the thinner the thickness of the transparent conductive layer, the more the total reflection effect increases.

Therefore, in the instance of a bifacial solar cell, by forming the second thickness of the back transparent conductive layer to be less than the first thickness of the front transparent conductive layer, the amount of light reflected from the back surface of the semiconductor substrate to the inside of the semiconductor substrate can be increased, thereby improving the efficiency of the solar cell.

In the instance of a bifacial solar cell, the first thickness of the front transparent conductive layer may be 70 nm to 100 nm, and the second thickness of the back transparent conductive layer may be 25 nm to 75 nm within a range less than the first thickness of the front transparent conductive layer.

In a bifacial solar cell, a front passivation layer may be located between the front doped layer and the semiconductor substrate, and a back passivation layer may be located between the back doped layer and the semiconductor substrate.

The front doped layer and the back doped layer may be formed of amorphous silicon containing impurities, and the front passivation layer and the back passivation layer may be formed of intrinsic amorphous silicon or a tunnel oxide.

Each of the front surface and the back surface of the semiconductor substrate may be formed as a texturing surface including a plurality of fine unevennesses.

Unlike the bifacial solar cell, in the instance of a mono-facial solar cell, the front collector electrode may include a plurality of finger electrodes extending in a first direction, and at least one bus bar electrode extending in a second direction orthogonal to the first direction and physically connected to the plurality of finger electrodes, and the back collector electrode may include a sheet electrode entirely covering a back surface of the back transparent conductive layer.

According to an experiment useful for understanding the invention, in the laminated structure of the silicon / transparent conductive layer / metal electrode, when parasitic absorption loss is caused by the metal, it can be seen that as the thickness of the transparent conductive layer increases, the parasitic absorption loss decreases.

Therefore, in the instance of a mono-facial solar cell, by forming the second thickness of the back transparent conductive layer to be greater than the first thickness of the front transparent conductive layer, the amount of light reflected from the back surface of the semiconductor substrate to the inside of the semiconductor substrate can be increased, thereby improving the efficiency of the solar cell.

In the instance of a mono-facial solar cell, the first thickness of the front transparent conductive layer may be 70 nm to 100 nm, and the second thickness of the back transparent conductive layer may be 70 nm to 500 nm within a range larger than the first thickness of the front transparent conductive layer.

On the other hand, in the instance of a mono-facial solar cell, like a bifacial solar cell, a front passivation layer may be located between the front doped layer and the semiconductor substrate, and a back passivation layer may be located between the back doped layer and the semiconductor substrate.

The front doped layer and the back doped layer may be formed of amorphous silicon containing impurities, and the front passivation layer and the back passivation layer may be formed of intrinsic amorphous silicon or a tunnel oxide.

In the instance of a mono-facial solar cell, each of the front surface and the back surface of the semiconductor substrate may be formed as a texturing surface including a plurality of fine unevennesses. Alternatively, the back surface of the semiconductor substrate may be formed of a substantially flat surface that does not include fine unevennesses.

According to this configuration, since the front transparent conductive layer having an oxygen content smaller than that of the back transparent conductive layer is formed to have a lower sheet resistance than that of the back transparent conductive layer, although reducing the size (width, etc.) of the front collector electrodes to reduce a shading loss due to the front collector electrodes, the front transparent conductive layer can transfer the charge well.

Since the back transparent conductive layer having an oxygen content relatively larger than that of the front transparent conductive layer is formed to have a lower light absorptance than the front transparent conductive layer, the amount of light absorbed in the back transparent conductive layer can be reduced.

Therefore, in the instance of a bifacial solar cell, since the second thickness of the back transparent conductive layer is less than the first thickness of the front transparent conductive layer, the amount of light reflected from the back surface of the semiconductor substrate to the inside of the semiconductor substrate can be increased, thereby improving the efficiency of the solar cell.

Further, in the instance of a mono-facial solar cell, since the second thickness of the back transparent conductive layer is formed to be greater than the first thickness of the front transparent conductive layer, the amount of light reflected from the back surface of the semiconductor substrate to the inside of the semiconductor substrate can be increased, thereby improving the efficiency of the solar cell.

### BRIEF DESCRIPTION OF THE DRAWINGS

FIG. 1 is a front view of a solar cell according to embodiments of the invention.
FIG. 2 is a cross-sectional view of a bifacial solar cell taken along line II-II of FIG. 1 according to one embodiment of the invention.
FIG. 3 is a cross-sectional view of a mono-facial solar cell taken along line II-II of FIG. 1 according to another embodiment of the invention.
FIG. 4 is a graph showing a relationship between an oxygen content and a light absorptance of a transparent conductive layer.
FIG.5 is a graph showing a relationship between an oxygen content and a sheet resistance of a transparent conductive layer.
FIG. 6 is a graph showing a relationship between a thickness of a back transparent conductive layer and reflection characteristic in a mono-facial solar cell and a bifacial solar cell according to embodiments of the invention.
FIG. 7 is a graph showing a relationship between a thickness of a back transparent conductive layer and an oxygen content and a short circuit current density in a bifacial solar cell according to an embodiment of the invention.

### DETAILED DESCRIPTION OF THE EMBODIMENTS

Reference will now be made in detail to embodiments useful for understanding the invention, examples of which are illustrated in the accompanying drawings. Since the invention may be modified in various ways and may have various forms, specific embodiments are illustrated in the drawings and are described in detail in the specification. However, it should be understood that the invention are not limited to specific disclosed embodiments, but include all modifications, equivalents and substitutes included within the technical scope of the invention.

The terms 'first', 'second', etc., may be used to describe various components, but the components are not limited by such terms. The terms are used only for the purpose of distinguishing one component from other components.

For example, a first component may be designated as a second component without departing from the scope of the embodiments of the invention. In the same manner, the second component may be designated as the first component.

The term "and/or" encompasses both combinations of the plurality of related items disclosed and any item from among the plurality of related items disclosed.

When an arbitrary component is described as "being connected to" or "being linked to" another component, this should be understood to mean that still another component(s) may exist between them, although the arbitrary component may be directly connected to, or linked to, the second component.

On the other hand, when an arbitrary component is described as "being directly connected to" or "being directly linked to" another component, this should be understood to mean that no other component exists between them.

The terms used in this application are used to describe only specific embodiments or examples, and are not intended to limit the invention. A singular expression can include a plural expression as long as it does not have an apparently different meaning in context.

In this application, the terms "include" and "have" should be understood to be intended to designate that illustrated features, numbers, steps, operations, components, parts or combinations thereof exist and not to preclude the existence of one or more different features, numbers, steps, operations, components, parts or combinations thereof, or the possibility of the addition thereof.

In the drawings, the thickness of layers, films, panels, regions, etc., are exaggerated for clarity. It will be understood that when an element such as a layer, film, region, or substrate is referred to as being "on" another element, it can be directly on the other element or intervening elements may also be present. In contrast, when an element is referred to as being "directly on" another element, there are no intervening elements present.

Unless otherwise specified, all of the terms which are used herein, including the technical or scientific terms, have the same meanings as those that are generally understood by a person having ordinary knowledge in the art to which the invention pertains.

The terms defined in a generally used dictionary must be understood to have meanings identical to those used in the context of a related art, and are not to be construed to have ideal or excessively formal meanings unless they are obviously specified in this application.

The following example embodiments of the invention are provided to those skilled in the art in order to describe the invention more completely. Accordingly, shapes and sizes of elements shown in the drawings may be exaggerated for clarity.

Example embodiments of the invention will be described with reference to the accompanying drawings.

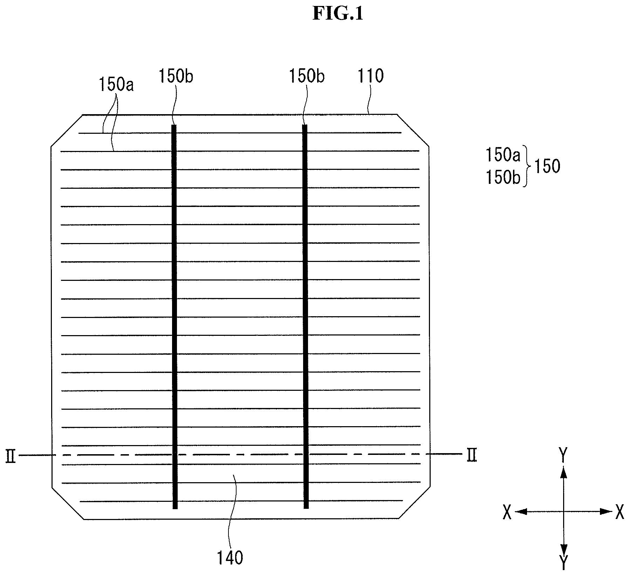

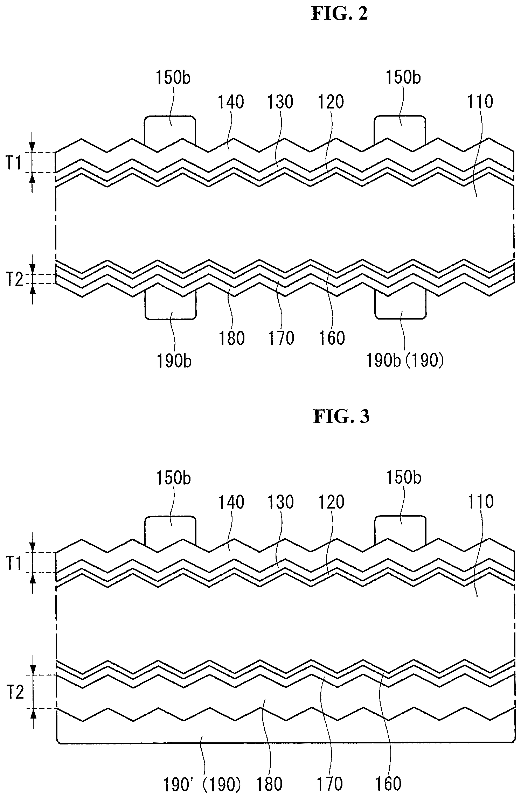

FIG. 1 is a front view of a solar cell according to embodiments of the invention. FIG. 2 is a cross-sectional view of a bifacial solar cell taken along line II-II of FIG. 1 according to one embodiment of the invention. FIG. 3 is a cross-sectional view of a mono-facial solar cell taken along line II-II of FIG. 1 according to another embodiment of the invention.

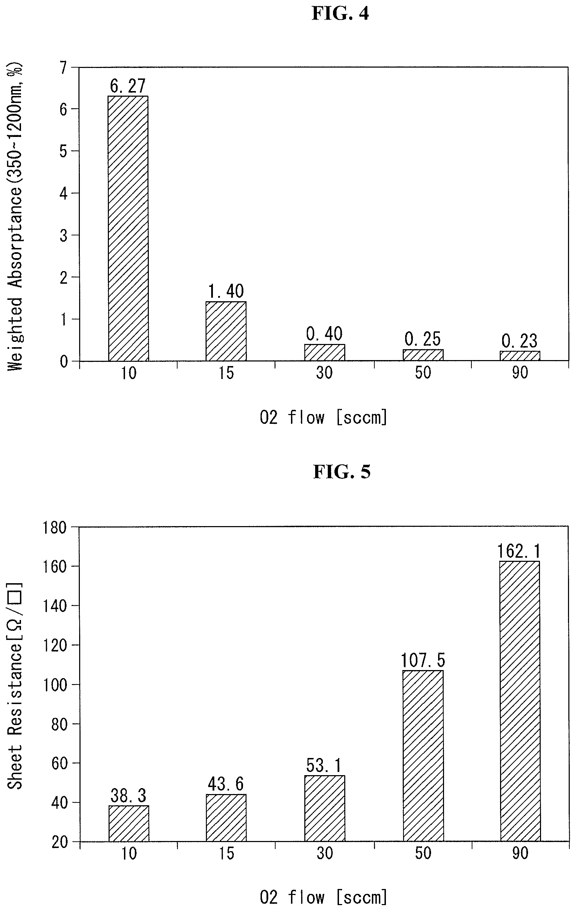

FIG. 4 is a graph showing a relationship between an oxygen content and a light absorptance of a transparent conductive layer. FIG.5 is a graph showing a relationship between an oxygen content and a sheet resistance of a transparent conductive layer.

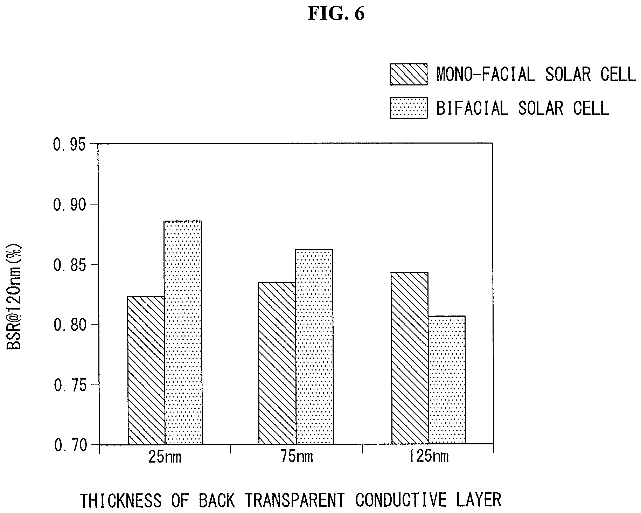

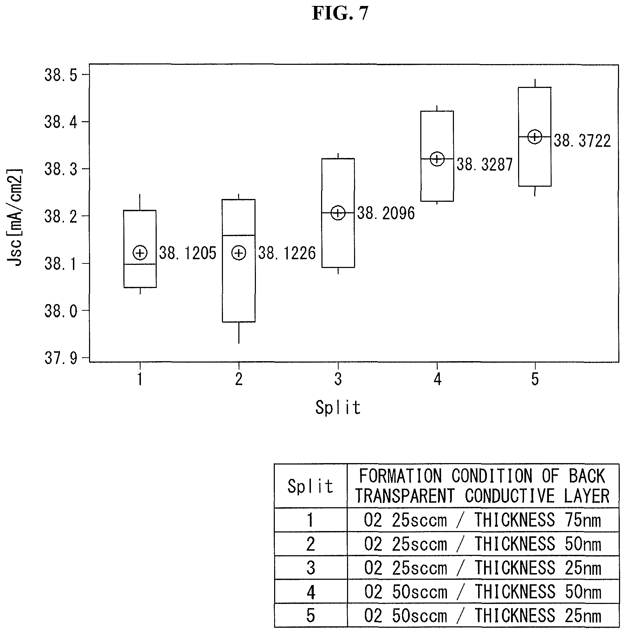

FIG. 6 is a graph showing a relationship between a thickness of a back transparent conductive layer and reflection characteristic in a mono-facial solar cell and a bifacial solar cell according to embodiments of the invention. FIG. 7 is a graph showing a relationship between a thickness of a back transparent conductive layer and an oxygen content and a short circuit current density in a bifacial solar cell according to an embodiment of the invention.

As shown in the drawings, a solar cell according to an embodiment of the invention includes a crystalline semiconductor substrate 110.

As shown in FIGS. 2 and 3, a front surface and a back surface of the semiconductor substrate 110 may be formed as a texturing surface including a plurality of fine unevennesses.

In contrast, in an instance of a mono-facial solar cell shown in FIG. 3, the back surface of the semiconductor substrate 110 may be formed as a substantially flat surface without fine unevennesses.

A front passivation layer 120, a front doped layer 130, a front transparent conductive layer 140, and a front collector electrode 150 are sequentially stacked on the front surface of the semiconductor substrate 110. A back passivation layer 160, a back doped layer 170, a back transparent conductive layer 180, and a back collector electrode 190 are sequentially stacked on the back surface of the semiconductor substrate 110.

Hereinafter, the term "front surface" refers to a surface facing upward in the accompanying drawings, and the term "back surface" refers to a surface facing downward in the accompanying drawings.

The substrate 110 is a semiconductor substrate 110 made of crystalline silicon containing impurities of a first conductivity type, for example, an n-type. In this instance, silicon may be single crystal silicon or polycrystalline silicon.

Since the substrate 110 has the n-type, the substrate 110 contains impurities of a group V element such as phosphorus (P), arsenic (As), antimony (Sb), or the like.

Alternatively, however, the substrate 110 may be a p-type and may be made of a semiconductor material other than silicon. When the substrate 110 has the p-type, the substrate 110 may contain impurities of a group III element such as boron (B), gallium (Ga), indium (In), or the like.

Hereinafter, an instance that the substrate 110 has the n-type will be described as an example.

The substrate 110 has a texturing surface whose surface is textured. More specifically, the substrate 110 includes both a front surface, on which the front passivation layer 120 is located, and a back surface, on which the back passivation layer 160 is located, as a texturing surface.

The front passivation layer 120 and the back passivation layer 160 may be formed of substantially intrinsic (i-type) amorphous silicon or may be formed of a tunnel oxide. The front passivation layer 120 and the back passivation layer 160 may be formed to have a thickness of approximately 5 nm on substantially the entire area of the front and back surfaces of the substrate 110.

In this instance, each of the front passivation layer 120 and the back passivation layer 160 has the same surface shape as the texturing surface of the substrate 110. That is, each of the front passivation layer 120 and the back passivation layer 160 has a texturing surface.

The front doped layer 130 located on the front passivation layer 120 is an impurity doped region of a second conductive type (for example, a p-type) opposite the conductive type of the substrate 110. The front doped layer 130 is formed of p-type amorphous silicon (p-a-Si) and forms a p-n junction and a hetero junction with the substrate 110.

Therefore, because the substrate 110 has the n-type and the front doped layer 130 has the p-type, the separated electrons move toward the substrate 110 and the separated holes move toward the front doped layer 130.

Unlike the embodiment, when the substrate 110 has the p-type, the front doped layer 130 has the n-type. In this instance, the separated holes move toward the substrate 110, and the separated electrons move toward the front doped layer 130.

The front transparent conductive layer 140 formed on the front doped layer 130 may be formed of a layer containing indium oxide (In₂O₃) as a main component and containing tin (Sn), zinc (Zn), tungsten (W), cerium (Ce) or hydrogen (H) as impurities, or a layer containing indium oxide as a main component and containing at least one of titanium (Ti) and tantalum (Ta) as impurities, or a layer containing zinc oxide (ZnO) as a main component and containing aluminum (Al), boron (B), or gallium (Ga) as impurities, or a layer containing tin oxide (SnO₂) as a main component and containing fluorine (F) as impurities.

The front transparent conductive layer 140 has an anti-reflection function for increasing the amount of light incident on the semiconductor substrate 110, and a function to transfer charges moved to the front doped layer 130 to the front collector electrode 150.

The front transparent conductive layer 140 having the above functions is formed with a first thickness T1 of approximately 70 nm to 100 nm in consideration of anti-reflection characteristics.

In this instance, the front doped layer 130 and the front transparent conductive layer 140 are formed to have the same surface shape as the texturing surface of the substrate 110.

The front collector electrode 150 located on the front transparent conductive layer 140 includes a plurality of finger electrodes 150a extending in a first direction X-X and spaced apart in parallel, and at least one bus bar electrode 150b extending in a second direction Y-Y orthogonal to the first direction X-X and physically connected to the plurality of finger electrodes 150a. The front collector electrode 150 is formed of a metal having excellent conductivity, for example, silver (Ag).

The back doped layer 170 is located under the back passivation layer 160 located on the back surface of the semiconductor substrate 110. The back doped layer 170 is an impurity doped region having a first conductivity type (for example, an n-type), which is the same as the conductive type of the substrate 110 and is made of n-type amorphous silicon. The back doped layer 170 forms a hetero junction with the substrate 110.

Thus, since the semiconductor substrate 110 and the back doped layer 170 have the n-type, the separated electrons move toward the back doped layer 170 and the separated holes move toward the front doped layer 130.

Unlike the embodiment, when the substrate 110 has the p-type, the back doped layer 170 has the p-type. In this instance, the separated holes move toward the back doped layer 170, and the separated electrons move toward the front doped layer 130.

The back transparent conductive layer 180 formed under the back doped layer 170, that is, on the back surface thereof, has a back reflect function, and a function to transfer charges moved to the back doped layer 170 to the back collector electrode 190.

The back transparent conductive layer 180 is formed of the same material as the front transparent conductive layer 140.

In this instance, "the same material" refers to a material having a main component and an impurity identical to each other, and the material having different types of impurities contained therein do not correspond to the same material.

That is, when the front transparent conductive layer 140 is made of In₂O₃: W (hereinafter referred to as "IWO"), that is, indium oxide (In₂O₃) as a main component containing tungsten (W) as an impurity, similarly to the front transparent conductive layer 140, the back transparent conductive layer 180 is made of IWO.

Alternatively, the front transparent conductive layer 140 and the back transparent conductive layer 180 may be formed of different materials.

Each of the back doped layer 170 and the back transparent conductive layer 180 has the same surface shape as the texturing surface of the substrate 110.

The back collector electrode 190 is located under the back transparent conductive layer 180, that is, on a lower part thereof.

As shown in FIG. 2, the back collector electrode 190 may have the same structure as the front collector electrode 150, that is, a finger electrode and a bus bar electrode 190b. As shown in FIG. 3, the back collector electrode 190 may include a sheet electrode 190' entirely covering a back surface of the back transparent conductive layer 180.

As shown in FIG. 2, the solar cell in which the front collector electrode 150 and the back collector electrode 190 are formed as the same structure can be used as a bifacial solar cell. As shown in FIG. 3, the solar cell in which the front collector electrode 150 and the back collector electrode 190' are formed as different structures can be used as a mono-facial solar cell.

In the bifacial and mono-facial solar cells, a region where the front collector electrode 150 is formed becomes a shading region where no light is incident.

Therefore, it is preferable but not required to reduce the size (width, etc.) of the front collector electrode 150 in order to reduce a shading loss due to the front collector electrode 150. However, if the size of the front collector electrode 150 is reduced, the charges moved toward the front doped layer 130 cannot be effectively collected.

Therefore, in the instance of the front transparent conductive layer 140, it is preferable but not required to consider the electrical characteristics rather than the optical characteristics.

However, in the instance of the back transparent conductive layer 180 located on the back surface of the semiconductor substrate 110, there is less restriction on the electrical characteristics as compared with the front transparent conductive layer 140.

Therefore, in the instance of the back transparent conductive layer 180, it is preferable but not required to further consider the optical characteristics rather than the electrical characteristics.

Thus, in the embodiment of the invention, by making content of a material, for example, oxygen, capable of controlling the electrical characteristics and optical characteristics of the transparent conductive layer depending on the content thereof different in the front transparent conductive layer 140 and the back transparent conductive layer 180, the sheet resistance of the front transparent conductive layer 140 is formed to be less than the sheet resistance of the back transparent conductive layer 180, and the light absorptance of the back transparent conductive layer 180 is formed to be less than the light absorptance of the front transparent conductive layer 140.

As a material capable of controlling the electrical characteristics and optical characteristics of the transparent conductive layer depending on the content thereof, there is hydrogen (H) in addition to oxygen. However, it is more preferable but not required to control the injection amount of oxygen when forming the transparent conductive layer because the control effect on the injection amount of oxygen is better than that of hydrogen (H).

FIG. 4 is a graph showing a relationship between oxygen content and light absorptance of a transparent conductive layer IWO. FIG. 5 is a graph showing a relationship between oxygen content and sheet resistance of a transparent conductive layer IWO.

Referring to FIG. 4, it can be seen that as the oxygen content of the transparent conductive layer IWO increases, the light absorptance decreases from 350 nm to 1200 nm. In the process of forming the transparent conductive layer IWO, it can be seen that the light absorptance is greatly reduced when the oxygen is injected in an amount of 15 sccm as compared with the instance of injecting oxygen in an amount of 10 sccm.

Referring to FIG. 5, it can be seen that as the oxygen content of the transparent conductive layer IWO increases, the sheet resistance increases. In the process of forming the transparent conductive layer IWO, it can be seen that the sheet resistance is greatly increased when the amount of oxygen is injected in an amount of 90 sccm as compared with the instance of injecting oxygen in an amount of 50 sccm.

Therefore, referring to FIGS. 4 and 5, when the back transparent conductive layer 180 is formed, it is preferable but not required to inject oxygen in an amount of 15 sccm to 50 sccm to improve the optical characteristics and electrical characteristics of the back transparent conductive layer 180. It is more preferable but not required to inject oxygen in an amount of 15 sccm to 30 sccm.

Since it is preferable but not required that the front transparent conductive layer 140 consider the electrical characteristics more than the optical characteristics as compared with the back transparent conductive layer 180, when the front transparent conductive layer 140 is formed, it can be seen that it is preferable but not required to inject oxygen in an amount less than 15 sccm, especially less than 10 sccm.

Therefore, in the solar cell according to an embodiment of the invention, the oxygen content of the front transparent conductive layer 140 is formed to be smaller than the oxygen content of the back transparent conductive layer 180. Accordingly, the sheet resistance of the front transparent conductive layer 140 is formed to be smaller than the sheet resistance of the back transparent conductive layer 180.

On the other hand, according to an experiment of the invention, in the laminated structure of the silicon / transparent conductive layer as the bifacial solar cell shown in FIG. 2, the thinner the thickness of the transparent conductive layer, the more the total reflection effect increases. As a result, it can be seen that the reflection characteristics increases.

In the laminated structure of the silicon / transparent conductive layer / metal electrode as the mono-facial solar cell shown in FIG. 3, as the thickness of the transparent conductive layer increases, the parasitic absorption loss due to the metal decreases. As a result, it can be seen that the reflection characteristics increases.

FIG. 6 is a graph showing a relationship between a thickness of a back transparent conductive layer and reflection characteristic in a mono-facial solar cell and a bifacial solar cell. Referring to FIG. 6, in an instance of the mono-facial solar cell, the back reflection characteristic (BSR @ 1200 nm) increases as the thickness of the back transparent conductive layer 180 increases. In an instance of the bifacial solar cell, the back reflection characteristic increases as the thickness of the back transparent conductive layer 180 decreases.

Therefore, in the bifacial solar cell of the invention, a second thickness T2 of the back transparent conductive layer 180 is formed to be less than a first thickness T1 of the front transparent conductive layer 140. In the mono-facial solar cell, a second thickness T2 of the back transparent conductive layer 180 is formed to be greater than a first thickness T1 of the front transparent conductive layer 140.

As described above, since the front transparent conductive layer 140 is formed with the first thickness T1 of approximately 70 nm to 100 nm in consideration of the anti-reflection characteristic, in the instance of the bifacial solar cell shown in FIG. 2, the second thickness T2 of the back transparent conductive layer 180 is formed within a range less than the first thickness T1 of the front transparent conductive layer 140, in the instance of the mono-facial solar cell shown in FIG. 3, the second thickness T2 of the back transparent conductive layer 180 is formed within a range larger than the first thickness T1 of the front transparent conductive layer 140.

FIG. 7 is a graph showing a relationship between a thickness of a back transparent conductive layer, oxygen content, and short circuit current density in a bifacial solar cell.

In FIG. 7, split 1 is a sample formed with a thickness of 75 nm while injecting oxygen in an amount of 25 sccm. Split 2 is a sample formed with a thickness of 50 nm while injecting oxygen in an amount of 25 sccm. Split 3 is a sample formed with a thickness of 25 nm while injecting oxygen in an amount of 25 seem.

Split 4 is a sample formed with a thickness of 50 nm while injecting oxygen in an amount of 50 sccm. Split 5 is a sample formed with a thickness of 25 nm while injecting oxygen in an amount of 50 seem.

Referring to FIG. 7, in the samples (Split 1 to 3) in which oxygen is injected in the same amount, it can be seen that the short circuit current density Jsc increases as the thickness of the back transparent conductive layer 180 decreases. In the samples (Split 2 and Split 4, and Split 3 and Split 5) having the same thickness, it can be seen that the short circuit current density Jsc increases as the oxygen injection amount increases.

When the second thickness T2 of the back transparent conductive layer 180 is 25 nm or more, a good short circuit current density Jsc can be obtained.

Therefore, in a bifacial solar cell, it is preferable but not required that the second thickness T2 of the back transparent conductive layer 180 is formed to be 25 nm or more within a range less than the first thickness T1 of the front transparent conductive layer 140. In particular, it can be seen that it is preferable but not required that the second thickness T2 of the back transparent conductive layer 180 is formed to be 25 nm to 75 nm.

In the instance of a mono-facial solar cell, as the second thickness T2 of the back transparent conductive layer 180 increases, the back reflection characteristic increases. Thus, it is preferable but not required that the second thickness T2 is thickened. However, the second thickness T2 is preferably but not necessarily 500 nm or less considering the material cost of the back transparent conductive layer 180 and bowing of the substrate.

Accordingly, in a mono-facial solar cell, the second thickness T2 of the back transparent conductive layer 180 may be formed to be 70 nm to 500 nm within a range larger than the first thickness T1 of the front transparent conductive layer 140.

The above-described solar cells (bifacial type and mono-facial type) can be manufactured as a solar cell module by a modularization process.

The solar cell module can be manufactured by carrying out a lamination process by positioning a plurality of solar cells electrically connected with adjacent solar cells by an interconnector or a ribbon between a pair of substrates, and by placing a sealing material between both substrates.

Hereinafter, a method of manufacturing a solar cell according to an embodiment of the invention will be briefly described.

First, the n-type single crystal silicon substrate is cleaned to remove impurities, and etching is performed using an etching solution composed of an aqueous solution of sodium hydroxide. Thus, a semiconductor substrate 110 having texturing surfaces formed on front and back surfaces of the silicon substrate is prepared.

Next, for example, using Radio-frequency (RF) plasma chemical vapor deposition (CVD) method, a front passivation layer 120 made of i-type amorphous silicon and a front doped layer 130 made of p-type amorphous silicon are sequentially formed on the front surface of the substrate 110, and a back passivation layer 160 made of i-type amorphous silicon and a back doped layer 170 made of n-type amorphous silicon are sequentially formed on the back surface of the substrate 110.

Next, using the ion plating method, a front transparent conductive layer 140 is formed on the front doped layer 130. In this instance, as the layer material source, a sintered body of indium oxide powder containing a predetermined amount of tungsten powder for doping the impurity can be used.

Also, using the ion plating method, a back transparent conductive layer 180 is formed under the back doped layer 170, that is, on the back surface of the back doped layer 170.

In this instance, the back transparent conductive layer 180 is formed of the same material as the front transparent conductive layer 140. By injecting a larger amount of oxygen into the back transparent conductive layer 180 than the amount of oxygen to be injected during formation of the front transparent conductive layer 140, the back reflection characteristic by the back transparent conductive layer 180 is improved.

For example, when the front transparent conductive layer 140 is formed, oxygen is injected in an amount of less than 15 sccm, especially less than 10 sccm. When the back transparent conductive layer 180 is formed, oxygen is injected in an amount of 15 sccm to 50 sccm, preferably but not necessarily in an amount of 15 sccm to 30 sccm.

The front transparent conductive layer 140 is formed with a first thickness T1 of 70 nm to 100 nm. In the instance of the bifacial solar cell, the back transparent conductive layer 180 is formed with a second thickness T2 of 25 nm to 75 nm within a range less than the first thickness T1 of the front transparent conductive layer 140. In the instance of the mono-facial solar cell, the back transparent conductive layer 180 is formed with a second thickness T2 of 70 nm to 500 nm within a range larger than the first thickness T1 of the front transparent conductive layer 140.

Alternatively, the back transparent conductive layer 180 may be formed of a different material from the front transparent conductive layer 140.

An annealing process may be performed for a predetermined time at a predetermined temperature for crystallizing the front transparent conductive layer 140 and the back transparent conductive layer 180 formed by the manufacturing method described above.

Then, using a screen printing method, in a predetermined region on the front transparent conductive layer 140 and the back transparent conductive layer 180, a silver (Ag) paste formed by kneading a silver (Ag) powder into a thermosetting resin such as an epoxy resin is formed into a predetermined shape. By heating the predetermined shape for a set time at a set temperature, the silver (Ag) paste is cured to form the front collector electrode 150 and the back collector electrode 190.

In this instance, in the instance of the bifacial solar cell, a silver paste may be formed on the finger electrode region and the bus bar electrode region on the front transparent conductive layer 140 and the back transparent conductive layer 180. In the instance of the mono-facial solar cell, after the front collector electrode 150 is formed, the back collector electrode 190 may be formed by applying and curing a conductive paste as a whole on the back transparent conductive layer 180.

## Claims

1. A solar cell, comprising:
a crystalline semiconductor substrate (110) containing impurities of a first conductivity type;
a front doped layer (130) located on a front surface of the semiconductor substrate (110);
a back doped layer (170) located on a back surface of the semiconductor substrate (110);
a front transparent conductive layer (140) located on the front doped layer (130);
a front collector electrode (150) located on the front transparent conductive layer (140);
a back transparent conductive layer (180) located under the back doped layer (170); and
a back collector electrode (190) located under the back transparent conductive layer (180),
wherein a thickness (T1) of the front transparent conductive layer (140) and a thickness (T2) of the back transparent conductive layer (180) are different from each other, **characterized in that** a sheet resistance of the front transparent conductive layer (140) is less than a sheet resistance of the back transparent conductive layer (180) and
the front transparent conductive layer (140) has the thickness (T1) over its entire area and the back transparent conductive layer (180) has the thickness (T2) over its entire area.

2. The solar cell of claim 1, wherein the front transparent conductive layer (140) and the back transparent conductive layer (180) are formed of the same material.

3. The solar cell of claim 2, wherein the front transparent conductive layer (140) and the back transparent conductive layer (180) are formed of a layer containing indium oxide (In₂O₃) as a main component and containing tin (Sn), zinc (Zn), tungsten (W), cerium (Ce) or hydrogen (H) as impurities, or
a layer containing indium oxide as a main component and containing at least one of titanium (Ti) and tantalum (Ta) as impurities, or
a layer containing zinc oxide (ZnO) as a main component and containing aluminum (Al), boron (B), or gallium (Ga) as impurities, or
a layer containing tin oxide (SnO₂) as a main component and containing fluorine (F) as impurities.

4. The solar cell of claim 3, wherein an oxygen content of the back transparent conductive layer (180) is larger than an oxygen content of the front transparent conductive layer (140).

5. The solar cell of any one of claims 1 to 4, wherein each of the front collector electrode (150) and the back collector electrode (190) includes a plurality of finger electrodes (150a) extending in a first direction (X-X), and at least one bus bar electrode (150b, 190b) extending in a second direction (Y-Y) orthogonal to the first direction and physically connected to the plurality of finger electrodes (150a).

6. The solar cell of claim 5, wherein the thickness (T2) of the back transparent conductive layer (180) is less than the thickness (T1) of the front transparent conductive layer (140).

7. The solar cell of claim 6, wherein the thickness (T1) of the front transparent conductive layer (140) is 70 nm to 100 nm, and the thickness (T2) of the back transparent conductive layer is 25 nm to 75 nm.

8. The solar cell of any one of claims 5 to 7, further comprising:
a front passivation layer (120) located between the front doped layer (!30) and the semiconductor substrate (110); and
a back passivation layer (160) located between the back doped layer (170) and the semiconductor substrate (110).

9. The solar cell of claim 8, wherein the front doped layer (130) and the back doped layer (170) are formed of amorphous silicon containing impurities, and
wherein the front passivation layer (120) and the back passivation layer (160) are formed of intrinsic amorphous silicon or a tunnel oxide.

10. The solar cell of any one of claims 5 to 9, wherein each of the front surface and the back surface of the semiconductor substrate (110) is formed as a texturing surface including a plurality of fine unevennesses, and each of the front transparent conductive layer (140) and the back transparent conductive layer (180) is formed as a texturing surface including a plurality of fine unevennesses.

11. The solar cell of any one of claims 1 to 4, wherein the front collector electrode (150) includes a plurality of finger electrodes (150a) extending in a first direction (X-X), and at least one bus bar electrode (150b) extending in a second direction (Y-Y) orthogonal to the first direction (X-X) and physically connected to the plurality of finger electrodes (150a), and
wherein the back collector electrode (190) includes a sheet electrode (190') entirely covering a back surface of the back transparent conductive layer (180).

12. The solar cell of claim 11, wherein the thickness (T2) of the back transparent conductive layer (180) is greater than the thickness (T1) of the front transparent conductive layer (140).

13. The solar cell of claim 12, wherein the thickness (T1) of the front transparent conductive layer (150a) is 70 nm to 100 nm, and the thickness (T2) of the back transparent conductive layer (180) is 70 nm to 500 nm.

14. The solar cell of any one of claims 11 to 13, further comprising:
a front passivation layer (120) located between the front doped layer (130) and the semiconductor substrate (110); and
a back passivation layer (160) located between the back doped layer (170) and the semiconductor substrate (110),
wherein the front doped layer (130) and the back doped layer (170) are formed of amorphous silicon containing impurities, and
wherein the front passivation layer (120) and the back passivation layer (160) are formed of intrinsic amorphous silicon or a tunnel oxide.

15. The solar cell of any one of claims 11 to 14, wherein each of the front surface and the back surface of the semiconductor substrate (110) is formed as a texturing surface including a plurality of fine unevennesses, and each of the front transparent conductive layer (140) and the back transparent conductive layer (180) is formed as a texturing surface including a plurality of fine unevennesses.

## Patentansprüche

1. Solarzelle, umfassend:
ein kristallines Halbleitersubstrat (110) mit Störstoffen eines ersten Leitfähigkeitstyps;
eine vorderseitige dotierte Schicht (130), die auf einer Vorderseite des Halbleitersubstrats (110) angeordnet ist;
eine rückseitige dotierte Schicht (170), die auf einer Rückseite des Halbleitersubstrats (110) angeordnet ist;
eine vorderseitige transparente leitfähige Schicht (140), die auf der vorderseitigen dotierten Schicht (130) angeordnet ist;
eine vorderseitige Sammelelektrode (150), die auf der vorderseitigen transparenten leitfähigen Schicht (140) angeordnet ist;
eine rückseitige transparente leitfähige Schicht (180), die unter der rückseitigen dotierten Schicht (170) angeordnet ist; und
eine rückseitige Sammelelektrode (190), die unter der rückseitigen transparenten leitfähigen Schicht (180) angeordnet ist,
wobei eine Dicke (T1) der vorderseitigen transparenten leitfähigen Schicht (140) und eine Dicke (T2) der rückseitigen transparenten leitfähigen Schicht (180) voneinander verschieden sind,
**dadurch gekennzeichnet, dass** ein Schichtwiderstand der vorderseitigen transparenten leitfähigen Schicht (140) kleiner ist als ein Schichtwiderstand der rückseitigen transparenten leitfähigen Schicht (180) und
die vorderseitige transparente leitfähige Schicht (140) auf ihrer gesamten Fläche die Dicke (T1) aufweist und die rückseitige transparente leitfähige Schicht (180) auf ihrer gesamten Fläche die Dicke (T2) aufweist.

2. Solarzelle nach Anspruch 1, wobei die vorderseitige transparente leitfähige Schicht (140) und die rückseitige transparente leitfähige Schicht (180) aus dem gleichen Material gebildet sind.

3. Solarzelle nach Anspruch 2, wobei die vorderseitige transparente leitfähige Schicht (140) und die rückseitige transparente leitfähige Schicht (180) aus einer Schicht, die Indiumoxid (In₂O₃) als eine Hauptkomponente und Zinn (Sn), Zink (Zn), Wolfram (W), Cer (Ce) oder Wasserstoff (H) als Störstoffe enthält, oder
einer Schicht, die Indiumoxid als eine Hauptkomponente enthält und Titan (Ti) und/oder Tantal (Ta) als Störstoffe enthält, oder
einer Schicht, die Zinkoxid (ZnO) als eine Hauptkomponente enthält und Aluminium (Al), Bor (B) oder Gallium (Ga) als Störstoffe enthält, oder
einer Schicht gebildet sind, die Zinnoxid (SnO₂) als eine Hauptkomponente enthält und Fluor (F) als Störstoffe enthält.

4. Solarzelle nach Anspruch 3, wobei ein Sauerstoffgehalt der rückseitigen transparenten leitfähigen Schicht (180) größer ist als ein Sauerstoffgehalt der vorderseitigen transparenten leitfähigen Schicht (140).

5. Solarzelle nach einem der Ansprüche 1 bis 4, wobei sowohl die vorderseitige Sammelelektrode (150) als auch die rückseitige Sammelelektrode (190) eine Mehrzahl von Fingerelektroden (150a), die sich in einer ersten Richtung (X-X) erstrecken, und mindestens eine Sammelschienenelektrode (150b, 190b), die sich in einer zweiten Richtung (Y-Y) orthogonal zu der ersten Richtung erstreckt und physisch mit der Mehrzahl von Fingerelektroden (150a) verbunden ist, umfassen.

6. Solarzelle nach Anspruch 5, wobei die Dicke (T2) der rückseitigen transparenten leitfähigen Schicht (180) geringer ist als die Dicke (T1) der vorderseitigen transparenten leitfähigen Schicht (140).

7. Solarzelle nach Anspruch 6, wobei die Dicke (T1) der vorderseitigen transparenten leitfähigen Schicht (140) 70 nm bis 100 nm beträgt und die Dicke (T2) der rückseitigen transparenten leitfähigen Schicht 25 nm bis 75 nm beträgt.

8. Solarzelle nach einem der Ansprüche 5 bis 7, des Weiteren umfassend:
eine vorderseitige Passivierungsschicht (120), die zwischen der vorderseitigen dotierten Schicht (130) und dem Halbleitersubstrat (110) angeordnet ist; und
eine rückseitige Passivierungsschicht (160), die zwischen der rückseitigen dotierten Schicht (170) und dem Halbleitersubstrat (110) angeordnet ist.

9. Solarzelle nach Anspruch 8, wobei die vorderseitige dotierte Schicht (130) und die rückseitige dotierte Schicht (170) aus amorphem Silizium mit Störstoffen gebildet sind
und wobei die vorderseitige Passivierungsschicht (120) und die rückseitige Passivierungsschicht (160) aus intrinsisch amorphem Silizium oder einem Tunneloxid gebildet sind.

10. Solarzelle nach einem der Ansprüche 5 bis 9, wobei sowohl die Vorderseite als auch die Rückseite des Halbleitersubstrats (110) als eine strukturierte Oberfläche mit einer Mehrzahl von feinen Unebenheiten ausgebildet sind und wobei sowohl die vorderseitige transparente leitfähige Schicht (140) als auch die rückseitige transparente leitfähige Schicht (180) als eine strukturierte Oberfläche mit einer Mehrzahl von feinen Unebenheiten ausgebildet sind.

11. Solarzelle nach einem der Ansprüche 1 bis 4, wobei die vorderseitige Sammelelektrode (150) eine Mehrzahl von Fingerelektroden (150a), die sich in einer ersten Richtung (X-X) erstrecken, und mindestens eine Sammelschienenelektrode (150b), die sich in einer zweiten Richtung (Y-Y) orthogonal zu der ersten Richtung (X-X) erstreckt und physisch mit der Mehrzahl von Fingerelektroden (150a) verbunden ist, umfasst, und
wobei die rückseitige Sammelelektrode (190) eine Filmelektrode (190') umfasst, die eine Rückseite der rückseitigen transparenten leitfähigen Schicht (180) vollständig bedeckt.

12. Solarzelle nach Anspruch 11, wobei die Dicke (T2) der rückseitigen transparenten leitfähigen Schicht (180) größer ist als die Dicke (T1) der vorderseitigen transparenten leitfähigen Schicht (140).

13. Solarzelle nach Anspruch 12, wobei die Dicke (T1) der vorderseitigen transparenten leitfähigen Schicht (150a) 70 nm bis 100 nm beträgt und die Dicke (T2) der rückseitigen transparenten leitfähigen Schicht (180) 70 nm bis 500 nm beträgt.

14. Solarzelle nach einem der Ansprüche 11 bis 13, des Weiteren umfassend:
eine vorderseitige Passivierungsschicht (120), die zwischen der vorderseitigen dotierten Schicht (130) und dem Halbleitersubstrat (110) angeordnet ist; und
eine rückseitige Passivierungsschicht (160), die zwischen der rückseitigen dotierten Schicht (170) und dem Halbleitersubstrat (110) angeordnet ist,
wobei die vorderseitige dotierte Schicht (130) und die rückseitige dotierte Schicht (170) aus amorphem Silizium mit Störstoffen gebildet sind, und
wobei die vorderseitige Passivierungsschicht (120) und die rückseitige Passivierungsschicht (160) aus intrinsisch amorphem Silizium oder einem Tunneloxid gebildet sind.

15. Solarzelle nach einem der Ansprüche 11 bis 14, wobei sowohl die Vorderseite als auch die Rückseite des Halbleitersubstrats (110) als eine strukturierte Oberfläche mit einer Mehrzahl von feinen Unebenheiten ausgebildet sind und wobei sowohl die vorderseitige transparente leitfähige Schicht (140) als auch die rückseitige transparente leitfähige Schicht (180) als eine strukturierte Oberfläche mit einer Mehrzahl von feinen Unebenheiten ausgebildet sind.

## Revendications

1. Cellule solaire, comprenant :
un substrat semi-conducteur cristallin (110) contenant des impuretés d'un premier type de conductivité ;
une couche dopée avant (130) située sur une surface avant du substrat semi-conducteur (110) ;
une couche dopée arrière (170) située sur une surface arrière du substrat semi-conducteur (110) ;
une couche conductrice transparente avant (140) située sur la couche dopée avant(130) ;
une électrode collectrice avant (150) située sur la couche conductrice transparente avant (140) ;
une couche conductrice transparente arrière (180) située sous la couche dopée arrière (170) ; et
une électrode collectrice arrière (190) située sous la couche conductrice transparente arrière (180),
dans laquelle une épaisseur (T1) de la couche conductrice transparente avant (140) et une épaisseur (T2) de la couche conductrice transparente arrière (180) sont différentes l'une de l'autre, **caractérisée en ce qu'**une résistance de couche de la couche conductrice transparente avant (140) est inférieure à une résistance de couche de la couche conductrice transparente arrière (180) et
la couche conductrice transparente avant (140) a l'épaisseur (T1) sur toute sa surface et la couche conductrice transparente arrière (180) a l'épaisseur (T2) sur toute sa surface.

2. Cellule solaire selon la revendication 1, dans laquelle la couche conductrice transparente avant (140) et la couche conductrice transparente arrière (180) sont formées du même matériau.

3. Cellule solaire selon la revendication 2, dans laquelle la couche conductrice transparente avant (140) et la couche conductrice transparente arrière (180) sont constituées d'une couche contenant de l'oxyde d'indium (In₂O₃) en tant que constituant principal et contenant de l'étain (Sn), du zinc (Zn), du tungstène (W), du cérium (Ce) ou de l'hydrogène (H) en tant qu'impuretés, ou
une couche contenant de l'oxyde d'indium en tant que constituant principal et contenant du titane (Ti) et/ou du tantale (Ta) en tant qu'impuretés, ou
une couche contenant de l'oxyde de zinc (ZnO) en tant que constituant principal et contenant de l'aluminium (Al), du bore (B) ou du gallium (Ga) en tant qu'impuretés, ou
une couche contenant de l'oxyde d'étain (SnO₂) en tant que constituant principal et contenant du fluor (F) en tant qu'impureté.

4. Cellule solaire selon la revendication 3, dans laquelle une teneur en oxygène de la couche conductrice transparente arrière (180) est supérieure à une teneur en oxygène de la couche conductrice transparente avant (140).

5. Cellule solaire selon l'une quelconque des revendications 1 à 4, dans laquelle chacune de l'électrode collectrice avant (150) et de l'électrode collectrice arrière (190) comprend une pluralité d'électrodes en forme de doigt (150a) s'étendant dans une première direction (X-X), et au moins une électrode de barre omnibus (150b, 190b) s'étendant dans une seconde direction (Y-Y) orthogonale à la première direction et connectée physiquement à la pluralité d'électrodes en forme de doigt (150a).

6. Cellule solaire selon la revendication 5, dans laquelle l'épaisseur (T2) de la couche conductrice transparente arrière (180) est inférieure à l'épaisseur (T1) de la couche conductrice transparente avant (140).

7. Cellule solaire selon la revendication 6, dans laquelle l'épaisseur (T1) de la couche conductrice transparente avant (140) est comprise entre 70 nm et 100 nm, et l'épaisseur (T2) de la couche conductrice transparente arrière (180) est comprise entre 25 nm et 75 nm.

8. Cellule solaire selon l'une quelconque des revendications 5 à 7, comprenant en outre :
une couche de passivation avant (120) située entre la couche dopée avant (130) et le substrat semi-conducteur (110) ; et
une couche de passivation arrière (160) située entre la couche dopée arrière (170) et le substrat semi-conducteur (110).

9. Cellule solaire selon la revendication 8, dans laquelle la couche dopée avant (130) et la couche dopée arrière (170) sont formées de silicium amorphe contenant des impuretés, et
dans laquelle la couche de passivation avant (120) et la couche de passivation arrière (160) sont formées de silicium amorphe intrinsèque ou d'un oxyde tunnel.

10. Cellule solaire selon l'une quelconque des revendications 5 à 9, dans laquelle chacune de la surface avant et de la surface arrière du substrat semi-conducteur (110) est formée sous forme d'une surface de texturation comprenant une pluralité de fines irrégularités, et chacune de la couche conductrice transparente avant (140) et de la couche conductrice transparente arrière (180) est formée sous forme d'une surface de texturation comprenant une pluralité de fines irrégularités.

11. Cellule solaire selon l'une quelconque des revendications 1 à 4, dans laquelle l'électrode collectrice avant (150) comprend une pluralité d'électrodes en forme de doigt (150a) s'étendant dans une première direction (X-X), et au moins une électrode de barre omnibus (150b) s'étendant dans une seconde direction (Y-Y) orthogonale à la première direction (X-X) et physiquement connectée à la pluralité d'électrodes en forme de doigt (150a), et
dans laquelle l'électrode collectrice arrière (190) comprend une électrode en feuille (190') recouvrant entièrement une surface arrière de la couche conductrice transparente arrière (180).

12. Cellule solaire selon la revendication 11, dans laquelle l'épaisseur (T2) de la couche conductrice transparente arrière (180) est supérieure à l'épaisseur (T1) de la couche conductrice transparente avant (140).

13. Cellule solaire selon la revendication 12, dans laquelle l'épaisseur (T1) de la couche conductrice transparente avant (140) est comprise entre 70 nm et 100 nm, et l'épaisseur (T2) de la couche conductrice transparente arrière (180) est comprise entre 70 nm et 500 nm.

14. Cellule solaire selon l'une quelconque des revendications 11 à 13, comprenant en outre :
une couche de passivation avant (120) située entre la couche dopée avant (130) et le substrat semi-conducteur (110) ; et
une couche de passivation arrière (160) située entre la couche dopée arrière (170) et le substrat semi-conducteur (110),
dans laquelle la couche dopée avant (130) et la couche dopée arrière (170) sont formées de silicium amorphe contenant des impuretés, et
dans laquelle la couche de passivation avant (120) et la couche de passivation arrière (160) sont formées de silicium amorphe intrinsèque ou d'un oxyde tunnel.

15. Cellule solaire selon l'une quelconque des revendications 11 à 14, dans laquelle chacune de la surface avant et de la surface arrière du substrat semi-conducteur (110) est formée sous forme d'une surface de texturation comprenant une pluralité de fines irrégularités, et chacune de la couche conductrice transparente avant (140) et de la couche conductrice transparente arrière (180) est formée sous forme d'une surface de texturation comprenant une pluralité de fines irrégularités.
